# EUROPEAN PATENT APPLICATION

(11) **EP 1 973 140 A2**
(43) Date of publication of application: **24.09.2008**
(21) Application number: 08153090.9
(22) Date of filing: 20.03.2008
(51) Int. Cl.: H01J 37/32

(54) **Plasma species and uniformity control through pulsed VHF operation**

(30) Priority: 21.03.2007 US 689405
(71) Applicant: Applied Materials, Inc., Santa Clara CA 95052 (US)
(72) Inventor: Panagopoulos, Theodoros, San Jose, CA 95125 (US); Todorov, Valentin N., Palo Alto, CA 94301 (US); Hatcher, Brian K., San Jose, CA 95136 (US); Katz, Dan, Saratoga, CA 95070 (US); Hammond IV., Edward P., Hillsborough, CA 94010 (US); Holland, John P., San Jose, CA 95126 (US); Paterson, Alexander, San Jose, CA 95120 (US)
(74) Representative: Peterreins, Frank

(57) **Abstract**

An apparatus for processing a substrate has a chamber (102), a high frequency power source (116), and a low frequency power source (118). The chamber has a first (104) and second (106) electrode disposed therein. The high frequency power source is electrically coupled to either the first or second electrode to supply a first RF signal. The low frequency power source electrically coupled to either the first or second electrode to supply a second RF signal. The first RF signal is pulsed on and off so as to enhance electron loss in the chamber.

## Description

### TECHNICAL FIELD

This invention relates to a substrate processing chamber. More particularly, the invention relates to control of plasma species and uniformity through pulsed VHF.

### BACKGROUND

Plasma etching and reactive ion etching (RIE) have become important processes in precision etching of certain workpieces such as substrates in the fabrication of semiconductor devices. The differences between plasma etching and reactive ion etching, which generally can be carried out in the same equipment, typically result from different pressure ranges employed and from the consequential differences in mean free path of excited reactant species in a processing chamber. The two processes are collectively referred to herein as plasma etching. Plasma etching is a "dry etching" technique and has a number of advantages over conventional wet etching in which the workpiece is generally immersed in a container of liquid etchant material. Some of the advantages include lower cost, reduced pollution problems, reduced contact with dangerous chemicals, increased dimensional control, increased uniformity, improved etch selectivity, and increased process flexibility.

As integrated circuit densities increase, device feature sizes decrease below 0.25 micron while the aspect ratio (i.e., ratio of feature height to feature width) of the device features increase above 10:1. Improved precision of the etch process is required to form these small device features having high aspect ratios. Additionally, an increased etch rate is desired to improve throughput and reduce costs for producing integrated circuits.

One type of plasma etch chamber utilizes two parallel plate electrodes to generate and maintain a plasma of the process gases between the plate electrodes. Typically, a parallel plate plasma etch chamber includes a top electrode and a bottom electrode. The bottom electrode typically serves as a substrate holder, and a substrate (or wafer) is disposed on the bottom electrode. The etch process is performed on a surface of the substrate that is exposed to the plasma.

Typically, one or more of the electrodes are connected to a power source. In a particular parallel plate reactor, those electrodes are connected to high frequency power sources. The power source connected to the upper electrode is typically operated at a higher frequency than the power source connected to the lower electrode. This configuration is believed to decouple ion energy and ion flux on the substrate to avoid damage on the substrate.

Another parallel plate reactor has two power sources connected to a lower electrode. The power sources are each operated at different frequencies in order to control the etching characteristics resulting on a substrate being processed.

Yet another parallel plate reactor includes three electrodes. A first electrode is adapted to support a substrate and is connected to a low frequency AC power source. A second electrode is disposed in parallel relationship with the first electrode and is connected to ground. A third electrode (i.e., the chamber body) disposed between the first and second electrode is powered by a high frequency AC power source.

Another conventional apparatus provides a single powered electrode reactor. High and low frequency power supplies are coupled to the single electrode in an effort to increase process flexibility, control and residue removal. The single electrode reactor includes a multistage passive filter network. The network is intended to perform the functions of coupling both power supplies to the electrode, isolating the low frequency power supply from the high frequency power supply and attenuating the undesired frequencies produced by mixing of the two frequencies in the nonlinear load represented by the reactor.

The frequency applied to the electrode may be VHF. However, as the size of the substrate increases, plasma reactors have also become larger to the point where the size of the reactor is no longer negligible. In a plasma environment, the electromagnetic wavelength is reduced by approximately a factor of 5 from its free space wavelength, such that its quarter wavelength may approach the dimensions of the plasma chamber. As a result, the plasma density across the reactor may no longer be uniform. This standing wave phenomenon is becoming more pre-dominant as the free space excitation frequency increases, the wavelength decreases. Furthermore, the high frequency resulting in a high plasma density can reduce the skin depth that may become small compared to the size of the reactor gap. As a result, a skin effect may occur where maximum plasma heating may be seen at the edge of the discharge.

The disparity in density of the plasma in the chamber causes variations of the processing parameters in the chamber, which results in inconsistent or non-uniform processing of substrates. Therefore, there is a need for a parallel plate plasma etch system that can substantially maintain process uniformity in light of the electromagnetic effects occurring at high frequencies.

### BRIEF DESCRIPTION OF THE DRAWINGS

The present invention is illustrated by way of example, and not by way of limitation, in the figures of the accompanying drawings.

FIG. 1 is a schematic diagram illustrating one embodiment of a substrate processing system.

FIG. 2 is a schematic diagram illustrating another embodiment of a substrate processing system.

FIG. 3 is a flow diagram illustrating a method for controlling plasma density in accordance with one embodiment.

FIG. 4 is a flow diagram illustrating a method for controlling plasma density in accordance with another embodiment.

FIG. 5 is a flow diagram illustrating a method for controlling plasma density in accordance with yet another embodiment.

FIG. 6 is a graph illustrating pulsing of an rf power to an electrode in accordance with one embodiment.

FIG. 7 is a graph illustrating pulsing of an rf power to an electrode in accordance with another embodiment.

FIG. 8 is a graph illustrating effects of pulsed power source on spatial ion density.

FIG. 9 is a graph illustrating effects of pulsed power source on electron temperature.

FIG. 10 is a graph illustrating effects of pulsed power source on plasma potential.

FIG. 11 is a graph illustrating a comparison of the electron energy probability function (eepf) for continuous wave and pulsed power source.

DETAILED DESCRIPTION

The following description sets forth numerous specific details such as examples of specific systems, components, methods, and so forth, in order to provide a good understanding of several embodiments of the present invention. It will be apparent to one skilled in the art, however, that at least some embodiments of the present invention may be practiced without these specific details. In other instances, well-known components or methods are not described in detail or are presented in simple block diagram format in order to avoid unnecessarily obscuring the present invention. Thus, the specific details set forth are merely exemplary. Particular implementations may vary from these exemplary details and still be contemplated to be within the spirit and scope of the present invention.

A method and apparatus for processing a substrate is described. A capacitively coupled processing chamber has a first electrode and a second electrode. The second electrode may be used to support the substrate. The first electrode may be disposed above the substrate parallel to the second electrode. A high frequency power source is electrically coupled to either the first or second electrode to supply a first RF signal. A low frequency power source electrically coupled to either the first or second electrode to supply a second RF signal. The first RF signal is pulsed on and off so as to generate electron loss in the chamber so as to control spatial plasma uniformity in the chamber.

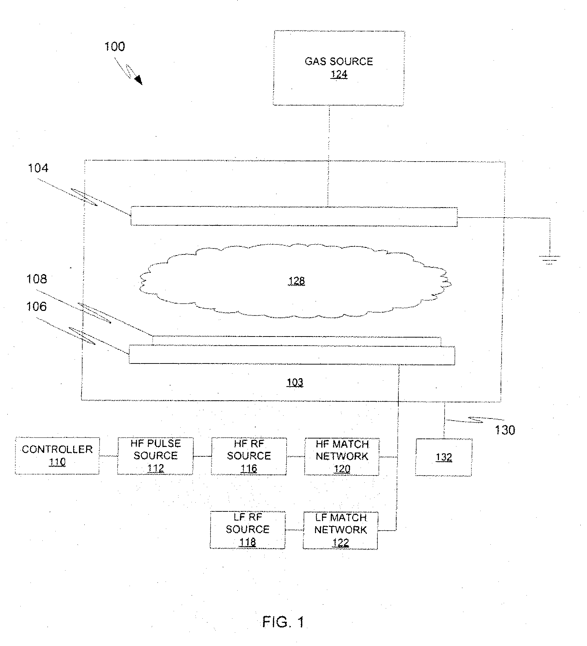

FIG. 1 is a schematic diagram of one embodiment of a parallel plate processing system 100. The processing system 100 may be attached to a processing system platform and may comprise a multi-purpose chamber configured to perform a specific process, such as an etch process. Although the invention is described with respect to a particular configuration, it is understood that the invention is applicable in a variety of configurations and designs. Further, it is understood that the system is a simplified schematic representation and some aspects that may be part of the processing system 100 are not shown. For example, actuators, valves, sealing assemblies and the like are not shown. Persons skilled in the art will readily recognize that these and other aspects may be incorporated into the processing system 100.

The process system 100 generally includes a chamber 102 having a cavity 103 at least part of which is a processing region. An opening (not shown) may be formed in a wall of the chamber 102 to facilitate substrate transfers into and out of the processing system 100. A bottom of the chamber 102 may include an outlet 130 for exhausting gases from the chamber 102. An exhaust system 132 may be attached to the outlet 130 of the bottom of the chamber 102. The exhaust system 132 may include components such as a throttle valve and a vacuum pump. Once the chamber 102 is sealed, exhaust system 132 may be operated to draw and maintain a vacuum within the cavity 103.

A top plate electrode 104 is disposed at an upper end of the chamber 102. In one embodiment, the plate electrode 104 may include a protective coating which prevents or reduces erosion of the material of the plate electrode 104 caused by the plasma in the chamber. The protective coating may comprise a material such as quartz, sapphire, alumina, SiC, SiN, and Si.

In one embodiment, the top plate electrode 104 may include a showerhead of a gas distribution system. In such a configuration, the top plate electrode 104 may be part of a lid assembly that is adapted to distribute gases into the cavity 103. Accordingly, FIG. 1 shows a gas source 124 coupled to the top plate electrode 104. The gas source 124 may contain a precursor or process gases to be utilized for processing a substrate 108 in the chamber 102. The gas source 124 may include one or more liquid ampoules containing one or more liquid precursors and one or more vaporizers for vaporizing the liquid precursors to a gaseous state. In accordance with one embodiment, the top plate electrode 104 and the chamber 102 may be grounded.

While the top plate electrode 104 acts as a top electrode of a parallel plate electrode plasma reactor, a substrate support 106 acts as a lower electrode. The substrate support 106 is disposed in the cavity 103 and may be any structure suitable for supporting the substrate 108 (e.g. a wafer or mask), such as an electrostatic chuck or a vacuum chuck. The substrate support 106 may include a support plate (not shown) defining a substrate supporting surface that is generally shaped to match the shape of the substrate 108 supported thereon. Illustratively, the substrate supporting surface is generally circular to support a substantially circular substrate. In one embodiment, the substrate supporting surface is thermally connected to a substrate temperature control system, such as a resistive heating coil and/or fluid passages connected to a heating or cooling fluid system.

The substrate support 106 may be connected to a low frequency RF power source 118 and a high frequency RF power source 116 for generating and maintaining plasma 128 in the chamber 102. In accordance with another embodiment, three different frequencies may be coupled to the cathode: a low frequency (LF), a medium frequency (MF), and a very high frequency VHF. The low frequency RF power source 116 may be connected to the supporting substrate 106 through a low frequency match network 122 and enhances ion assisted etching at the substrate 108. The high frequency RF power source 116, or a VHF power source may be connected to the supporting substrate 106 through a high frequency match network 120, or a VHF match network, and enhances dissociation of the process gases and plasma density. Those of ordinary skills in the art will recognize that each of the match networks 120, 122 may include one or more capacitors, inductors and other circuit components. The low frequency RF power source 118 may deliver RF power to the supporting substrate 106 at a frequency at or below about 20 MHz while the high frequency RF power source 116 may deliver RF power to the supporting substrate 106 at a frequency at or above 13.56 MHz. In one embodiment, the low frequency RF power source 122 delivers RF power to the supporting substrate 106 at a frequency between about 100 kHz and about 20 MHz while the high frequency RF power source 116, or a VHF power source delivers RF power to the supporting substrate 106 at a frequency between about 27MHz and about 200 MHz. Preferably, the high and low frequencies do not overlap during operation. That is, the low frequency RF power source 118 is operated at a frequency below the frequency of the high frequency RF power source 116, or a VHF power source.

A periodic high frequency pulse source 112 may turn the RF output of high frequency RF power source 116 on and off periodically. When the periodic high frequency pulse source 112 turns high frequency RF power source 116 on, the amplitude of the RF voltage applied to the substrate support 106 is sufficiently high to generate an electromagnetic field to excite the gas from gas source 124 to a plasma state 128. When the periodic high frequency pulse source 112 turns high frequency RF power source 116 off, the amplitude of the RF voltage applied to the substrate support 106 is insufficient to excite the gas from gas source 124 to the plasma state 128.

A controller 110 is connected to the high frequency pulse source 112. The controller 110 sends a signal to high frequency pulse source 112 to control a duty signal of the high frequency RF source 116. Furthermore, the controller 110 may be used to control the period of time over which pulsing occurs and the period of time over which no pulsing occurs.

In accordance with another embodiment, the low frequency RF power source 118, and the low frequency match network 122 may be either connected to the top or bottom electrode. FIG. 1 illustrates one embodiment where the low frequency RF power source 118, and the low frequency match network 122 are connected to a bottom electrode, e.g. the substrate support 106.

In accordance with another embodiment, the high frequency pulse source 112, the high frequency RF power source 116, and the high frequency match network 120 may be either connected to the top or bottom electrode. FIG. 1 illustrates one embodiment where the high frequency pulse source 112, the high frequency RF power source 116, and the high frequency match network 120 are connected to a bottom electrode, e.g. the substrate support 106.

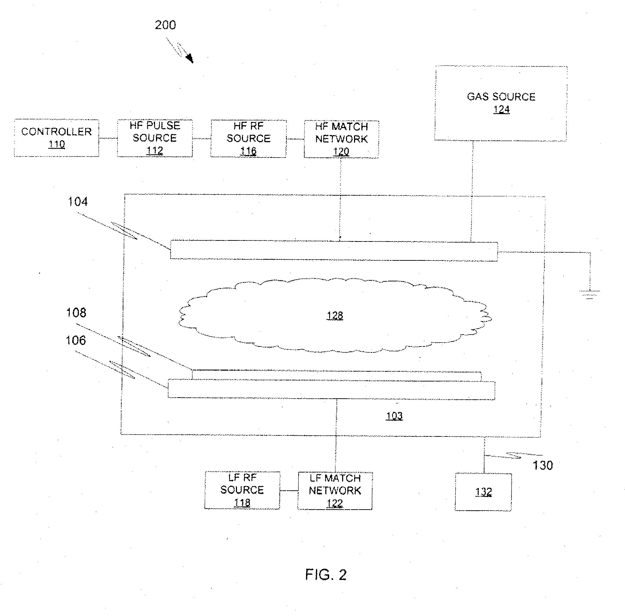

FIG. 2 illustrates another embodiment where the low frequency RF power source 118, and the low frequency match network 122 are connected to a bottom electrode, e.g. the substrate support 106. The high frequency pulse source 112, the high frequency RF power source 116, and the high frequency match network 120 are connected to the top electrode 104.

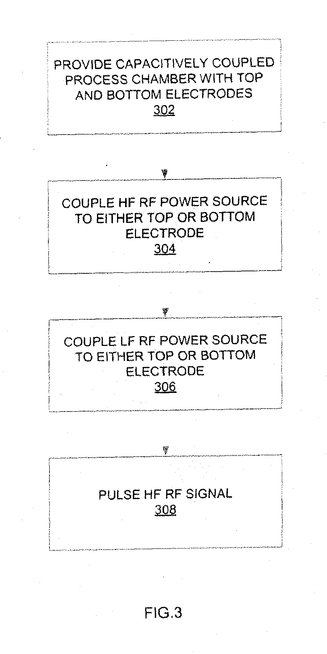

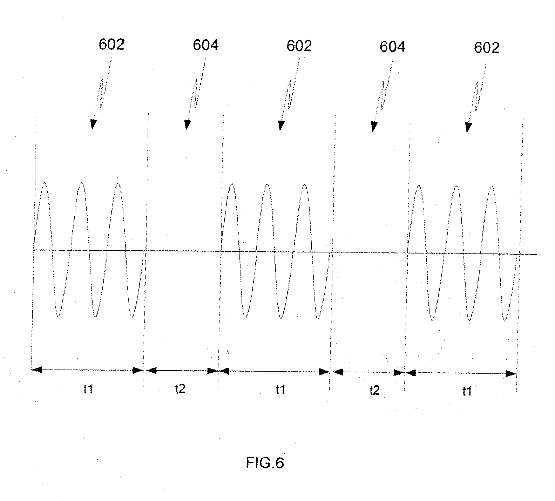

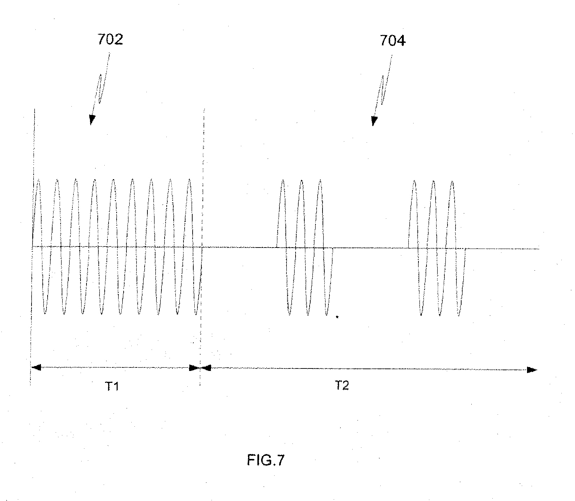

FIG. 3 is a flow diagram illustrating a method for controlling plasma density in accordance with one embodiment. At 302, a capacitively coupled processing system is provided. A chamber has a top and a bottom planar electrode. The electrodes may be parallel to each other. The bottom electrode may be used to support a substrate to be processed. An example of the capacitively coupled processing system is described above with respect to FIG. 1 and 2. At 304, a high frequency RF power source is coupled to either the top or bottom electrode. At 306, a low frequency RF power source is coupled to either the top or bottom electrode. At 308, the RF signals provided by the high frequency RF power source to the top or bottom electrode are pulsed so as to control the ion and electron density of the plasma in the chamber. An example of the pulsing duty cycle is described below and illustrated in FIGS. 6 and 7. Therefore, electron production and loss in the plasma can be manipulated by controlling the pulsing of the RF power supplied to the top or/and bottom electrode. By promoting electron loss, the standing wave effect can be substantially prevented when a chamber is operated with high frequency power sources. The control of the pulsing of the RF power sources can lead further control of plasma etching process (e.g. control of spatial plasma uniformity, control of plasma species, production of low energy electron, control of reduced plasma potential, etc...).

In accordance with one embodiment, the plasma uniformity can be optimized in the chamber by applying pulsed high frequency power sources to the electrode in the chamber. The high frequencies which are pulsed may range from about 27MHz to about 200MHz. The pulse period may be from about 1 usec to about 1000usec. The duty cycle may be from about 1% to about 100%. The duty cycle may be used to control plasma density uniformity of the plasma in the chamber. The pulsed high frequency capacitive plasma produces a novel plasma environment that cannot be obtained with traditional continuous wave usage.

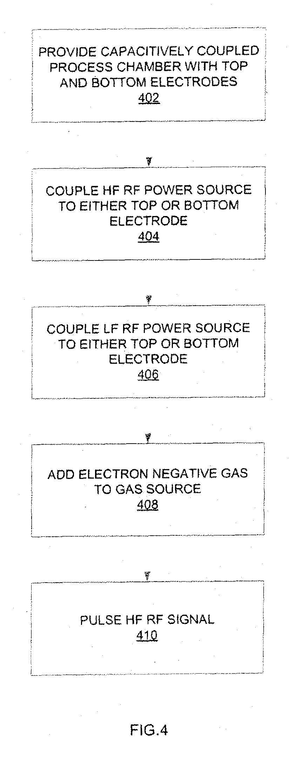

FIG. 4 is a flow diagram illustrating a method for controlling plasma density in accordance with another embodiment. At 402, a capacitively coupled processing system is provided. A chamber has a top and a bottom planar electrode. The electrodes may be parallel to each other. The bottom electrode may be used to support a substrate to be processed. An example of the capacitively coupled processing system is described above with respect to FIG. 1 and 2. At 404, a high frequency RF power source is coupled to either the top or bottom electrode. At 406, a low frequency RF power source is coupled to either the top or bottom electrode. At 408, an additive is added to the gas recipe for the chamber. The additive may be any component that contributes to generate electron loss of the plasma in the chamber. For example, the additive may be an electron negative gas addition such as sulfur-hexaflouride (SF6) or trifluormethane (CF4). At 410, the RF signals provided by the high frequency RF power source to the top or bottom electrode is pulsed so as to control the ion and electron density of the plasma in the chamber. An example of the pulsing duty cycle is described below and illustrated in FIGS. 6 and 7. Therefore, electron loss in the plasma can be enhanced by controlling the pulsing of the RF power supplied to the top or bottom electrode and controlling the gas supply to the chamber. By promoting electron loss, the standing wave effect can be substantially prevented when a chamber is operated with high frequency power sources. The control of the pulsing of the high frequency RF power source along with the gas supply modification can lead further control of plasma etching process (e.g. control of spatial plasma uniformity, control of plasma species, production of low energy electron, control of reduced plasma potential, etc...).

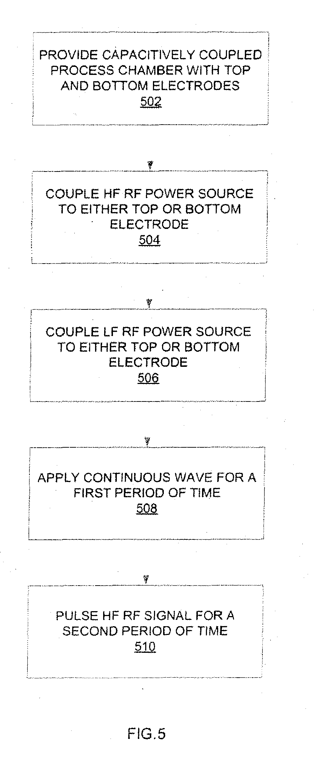

FIG. 5 is a flow diagram illustrating a method for controlling plasma density in accordance with yet another embodiment. At 502, a capacitively coupled processing system is provided. A chamber has a top and a bottom planar electrode. The electrodes may be parallel to each other. The bottom electrode may be used to support a substrate to be processed. An example of the capacitively coupled processing system is described above with respect to FIG. 1 and 2. At 504, a high frequency RF power source is coupled to either the top or bottom electrode. At 506, a low frequency RF power source is coupled to either the top or bottom electrode. At 508, the high and low frequency RF power sources may supply a continuous wave RF signal to the electrodes in the chamber for a first period of time. At 510, the RF signals provided by the high frequency RF power source to the top or bottom electrode are pulsed so as to control the ion and electron density of the plasma in the chamber for a second period of time. The embodiment described in FIG. 5 illustrates a combination of running a continuous wave and pulsed high frequency RF signals in a same recipe. For example, a breakthrough and main etch process may be accomplished in the first period of time with the continuous wave. An over-etch process may be accomplished in the second period of time with the pulsed high frequency RF signals.

FIG. 6 is a graph illustrating pulsing of a high frequency RF power source to an electrode in a capacitively coupled plasma etching chamber. The on cycle 602 are separated by an off cycle 604 where no RF power is supplied to the electrode. During the on cycle 602, a high frequency RF power is supplied to the electrode for a limited amount of time t1. The off cycle 604 may last for a limited amount of time t2. The duty cycle may be defined as a ratio of t1 over t2.

FIG. 7 is a graph illustrating pulsing of a high frequency RF power source to an electrode in accordance with another embodiment. During a first period of time T1, a continuous wave signal 702 is supplied to the electrode in a capacitively coupled plasma etching chamber. During a second period of time T2, a pulsed RF signal 704 is supplied to the electrode.

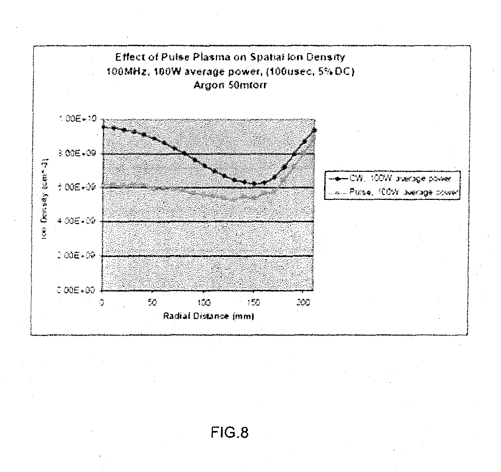

FIG. 8 is a graph illustrating effects of pulsed power source on spatial ion density.

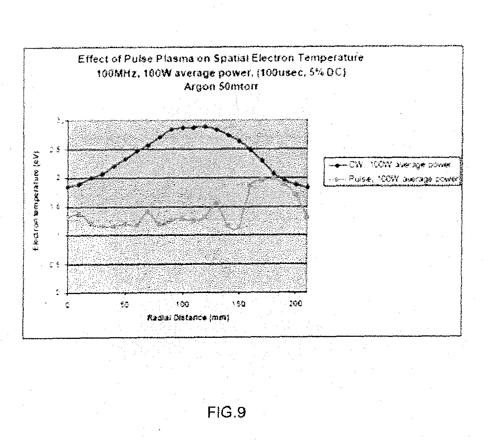

FIG. 9 is a graph illustrating effects of pulsed power source on electron temperature. The electron temperature can be manipulated and reduced with the use of the pulsed high frequency RF signals to further control any plasma damage.

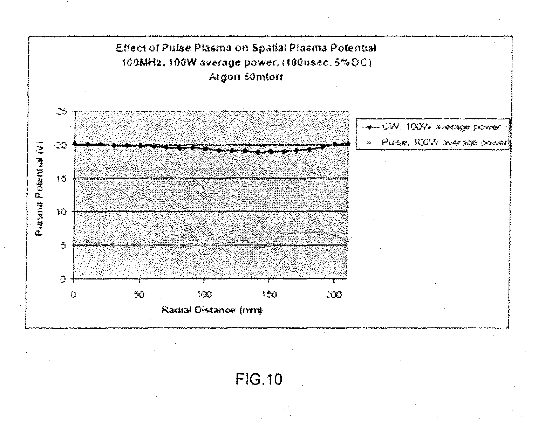

FIG. 10 is a graph illustrating effects of pulsed power source on plasma potential. The plasma potential can be manipulated and reduced with the use of the pulsed high frequency RF signals for soft etch requirements. This can be important for low-k etching.

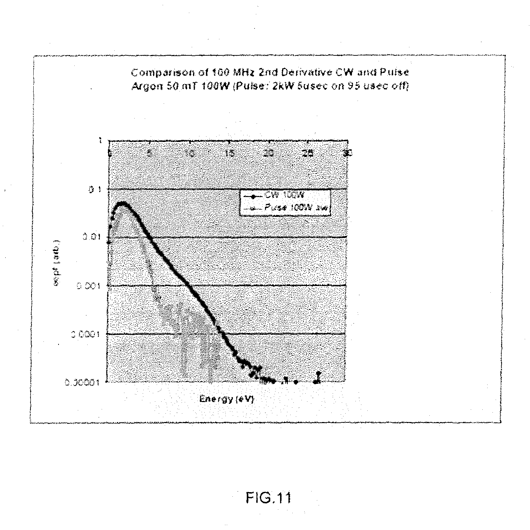

FIG. 11 is a graph illustrating a comparison of the electron energy probability function (eepf) for continuous wave and pulsed power source. The electron energy probability function (eepf) can be manipulated with the use of the pulsed high frequency RF signals to control the dissociation level in the plasma in the chamber.

Although the operations of the method(s) herein are shown and described in a particular order, the order of the operations of each method may be altered so that certain operations may be performed in an inverse order or so that certain operation may be performed, at least in part, concurrently with other operations. In another embodiment, instructions or sub-operations of distinct operations may be in an intermittent and/or alternating manner.

In the foregoing specification, the invention has been described with reference to specific exemplary embodiments thereof. It will, however, be evident that various modifications and changes may be made thereto without departing from the broader spirit and scope of the invention as set forth in the appended claims. The specification and drawings are, accordingly, to be regarded in an illustrative sense rather than a restrictive sense.

## Claims

1. An apparatus for processing a substrate comprising:
a chamber having a first and second electrode disposed therein;
a high frequency power source electrically coupled to either the first or second electrode to supply a first RF signal;
a low frequency power source electrically coupled to either the first or second electrode to supply a second RF signal;
wherein the first RF signal has a variable amplitude.

2. The apparatus of claim 1 wherein the variable amplitude is in the form of pulses.

3. The apparatus of claim 1 wherein the high frequency power sources range from about 27MHz to about 200MHz.

4. The apparatus of claim 2 wherein a period of the pulses ranges from about 1 µsec to 1000µsec.

5. The apparatus of claim 2 wherein a duty cycle of the pulses ranges from about 1% to about 100%.

6. The apparatus of claim 1 wherein the first RF signal is pulsed on and off so as to enhance electron loss in the chamber to substantially prevent a standing wave effect in the chamber.

7. The apparatus of claim 6 further comprising:
a gas supply chamber coupled to the chamber, the gas supply chamber comprising an electron negative gas additive to further enhance electron loss.

8. The apparatus of claim 1 wherein the first electrode is parallel to the second electrode, the second electrode to support the substrate.

9. A method for controlling plasma in a capacitively coupled processing chamber comprising:
providing a chamber having a first and second electrode disposed therein;
coupling a high frequency power source to either the first or second electrode;
coupling a low frequency power source to either the first or second electrode; and
changing an amplitude of the high frequency power source to control ion and electron density of the plasma.

10. The method of claim 9 wherein changing the amplitude further comprises:
pulsing the high frequency power source on and off.

11. The method of claim 9 wherein the high frequency power source ranges from about 27MHz to about 200MHz.

12. The method of claim 10 wherein a period of the pulses ranges from about 1µsec to 1000µsec.

13. The method of claim 10 wherein a duty cycle of the pulses ranges from about 1% to about 100%.

14. The method of claim 10 further comprising:
controlling a spatial plasma uniformity in the chamber with the pulsing.

15. The method of claim 10 further comprising:
controlling plasma species in the chamber with the pulsing.

16. The method of claim 10 further comprising:
producing low energy electron in the chamber with the pulsing.

17. The method of claim 10 further comprising:
reducing plasma potential in the chamber with the pulsing.

18. The method of claim 10 further comprising:
applying continuous waves to the first or second electrode in addition to the pulsing.

19. The method of claim 9 further comprising:
introducing an electron negative gas additive to a gas supply chamber coupled to the chamber so as to further enhance electron loss in the chamber to substantially prevent a standing wave effect.

20. A system for controlling plasma in a capacitively coupled processing chamber comprising:
the chamber having a first and second electrode therein; and
means for generating electron loss in the chamber so as to substantially eliminate a standing wave effect in the chamber as a result of a very high frequency being applied to the first or second electrode, the means coupled to the chamber.

21. The system of claim 20 wherein the means for generating electron loss comprise:
a very high frequency pulsing source coupled to the first or second electrode in the chamber.
